(19) Europäisches Patentamt
European Patent Office
Office européen des brevets

(11) **EP 3 481 662 B1**

(12) **EUROPÄISCHE PATENTSCHRIFT**

(45) Veröffentlichungstag und Bekanntmachung des Hinweises auf die Patenterteilung:
**10.06.2020 Patentblatt 2020/24**

(21) Anmeldenummer: **17742964.4**

(22) Anmeldetag: **10.07.2017**

(51) Int Cl.:
*B60K 37/06* (2006.01)       *B60K 35/00* (2006.01)
*B06B 1/04* (2006.01)        *G05G 5/03* (2008.04)
*G06F 3/01* (2006.01)        *G06F 3/0338* (2013.01)

(86) Internationale Anmeldenummer:
**PCT/EP2017/067283**

(87) Internationale Veröffentlichungsnummer:
**WO 2018/007646 (11.01.2018 Gazette 2018/02)**

(54) **BEDIENEINHEIT FÜR EIN FAHRZEUG**

OPERATOR CONTROL UNIT FOR A VEHICLE

UNITÉ DE COMMANDE POUR UN VÉHICULE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.07.2016 DE 102016212524**

(43) Veröffentlichungstag der Anmeldung:
**15.05.2019 Patentblatt 2019/20**

(73) Patentinhaber: **Behr-Hella Thermocontrol GmbH 70469 Stuttgart (DE)**

(72) Erfinder:
• **BESCHNITT, Alexander 32052 Herford (DE)**

• **PANKRATZ, Harri 59505 Bad Sassendorf (DE)**

(74) Vertreter: **dompatent von Kreisler Selting Werner - Partnerschaft von Patent- und Rechtsanwälten mbB Deichmannhaus am Dom Bahnhofsvorplatz 1 50667 Köln (DE)**

(56) Entgegenhaltungen:
**WO-A1-01/54109            WO-A1-2017/045975**
**DE-B3-102012 221 107     JP-A- 2003 058 321**

**Beschreibung**

Die Erfindung betrifft eine Bedieneinheit für ein Fahrzeug, bei der es sich beispielsweise um ein Infotainment-System zur Steuerung diverser Fahrzeugkomponenten handeln kann.

Bedieneinheiten mit Display-Baugruppen, auf denen beispielsweise menügesteuert verschiedene Symbolfelder darstellbar sind, über die Funktionen für eine Fahrzeugkomponente ausgewählt werden können, erfreuen sich zunehmender Beliebtheit. Dabei soll dem Bediener die Auswahl einer Funktion taktil bestätigt werden, was beispielsweise durch eine zusätzliche aktive Bewegung des Bedienelements nach dessen Betätigung erfolgt. Dieses haptische Feedback soll, über die gesamte Bedienoberfläche des Bedienelements betrachtet, möglichst homogen sein. Beispiele für derartige Bedieneinheiten sind in DE-A-10 2008 035 907 und DE-A-10 2009 007 243 beschrieben. In DE-A-100 43 805 ist darüber hinaus eine Vorrichtung mit einem elektromagnetischen Aktuator beschrieben.

Aus JP-A-2003 058 321 ist eine Bedieneinheit nach dem Oberbegriff des Anspruchs 1 bekannt.

Aus DE-B-10 2012 221 107 ist eine Bedienvorrichtung mit einer displaylosen Bedienelementleiste bekannt, die eine Parallelführungsaufhängung aufweist und beim Aufbringen eines vertikal wirkenden Moments zur taktiellen Rückmeldung der Betätigung pulsartig in Vibration versetzt wird.

Aufgabe der Erfindung ist es, eine Bedieneinheit für ein Fahrzeug zu schaffen, die mit mindestens einem Bedienelement mit Bedienoberfläche versehen ist, wobei das haptische Empfinden unabhängig vom Ort, an dem die Bedienoberfläche berührt und betätigt wird, im Wesentlichen gleich sein soll, und die mit einem aktiven haptischen Feedback ausgerüstet ist.

Zur Lösung dieser Aufgabe wird mit der Erfindung eine Bedieneinheit für ein Fahrzeug vorgeschlagen, wobei die Bedieneinheit versehen ist mit

- einem Gehäuse mit einer Vorderseite
- einem an der Vorderseite des Gehäuses angeordneten Bedienelement, das eine Bedienoberfläche aufweist,
- wobei das Bedienelement an und/oder in dem Gehäuse längs einer zur Bedienoberfläche im Wesentlichen orthogonal verlaufenden Vertikalbewegungsachse und längs einer im Wesentlichen quer dazu verlaufenden Lateralbewegungsachse mittels Rückholfedern elastisch gelagert ist,
- mindestens einem Sensor zur Erfassung einer Betätigungsbewegung des Bedienelements in Richtung der Vertikalbewegungsachse,
- einem in und/oder an dem Gehäuse angeordneten Aktuator zur Rückmeldebewegung des Bedienelements zumindest auch in der Lateralbewegungsachse bei einer erkannten Betätigungsbewegung des Bedienelements, wobei der Aktuator ein elektrisch ansteuerbares, mit dem Bedienelement mechanisch gekoppeltes Antriebselement aufweist, das längs einer Wirkbewegungsachse vor- und zurückbewegbar ist, und

- einer Auswerte- und Ansteuereinheit, die mit dem Sensor und dem Aktuator verbunden ist,
- wobei die Rückholfedern resultierende Federwirkachsen aufweisen, die parallel zur Wirkbewegungsachse des Aktuators verlaufen,
- wobei die Federwirkachsen der Rückholfedern bei Betrachtung in der Vertikalebene, in der die Wirkbewegungsachse des Aktuators verläuft und/oder in der der Massenschwerpunkt des Bedienelements oder der bewegbaren Masse aus u.a. dem Bedienelement und dem mit diesem gekoppelten Antriebselement des Aktuators liegt, beidseitig der Wirkbewegungsachse des Aktuators in ersten und zweiten Abständen zu der Wirkbewegungsachse des Aktuators verlaufen, und
- wobei die Dimensionierung der Rückholfedern hinsichtlich ihrer Federkräfte und der erste sowie der zweite Abstand zur im Wesentlichen Kompensation der infolge der Rückholfedern im Massenschwerpunkt des Bedienelements oder der bewegbaren Masse wirkenden Drehmomente gewählt sind.

Erfindungsgemäß ist vorgesehen, dass

- die Rückholfedern resultierenden Federwirkachsen aufweisen, die parallel zur Wirkbewegungsachse des Aktuators verlaufen,
- die Federwirkachsen der Rückholfedern bei Betrachtung in der Vertikalebene, in der die Wirkbewegungsachse des Aktuators verläuft und/oder in der der Massenschwerpunkt des Bedienelements oder der bewegbaren Masse aus u.a. dem Bedienelement und dem mit diesem gekoppelten Antriebselement des Aktuators liegt, beidseitig der Wirkbewegungsachse des Aktuators in ersten und zweiten Abständen zu der Wirkbewegungsachse des Aktuators verlaufen, und
- die Dimensionierung der Rückholfedern hinsichtlich ihrer Federkräfte und der erste sowie der zweite Abstand zur im Wesentlichen Kompensation der infolge der Rückholfedern im Massenschwerpunkt des Bedienelements oder der bewegbaren Masse wirkenden Drehmomente gewählt sind.

Nach der Erfindung wird das aktive haptische Feedback einer Betätigung des Bedienelements durch eine laterale Auslenkung des Bedienelements realisiert. Zur Betätigung wird das Bedienelement in einer im Wesentlichen orthogonal zur Bedienoberfläche verlaufenden Vertikalbewegungsachse bewegt. Wird dann über einen Sensor diese Betätigungsbewegung erfasst, erfolgt eine aktive Bewegung des Bedienelements in einer Lateralbewegungsrichtung (beispielsweise nach links oder rechts, nach oben oder nach unten). Dabei ist darauf zu achten, dass das Bedienelement nicht verkippt, was aber ohne besondere Maßnahmen dann nahezu ausgeschlossen ist, wenn, wie es der Normalfall ist, der Aktuator nicht im Massenschwerpunkt des Bedienelements mit diesem verbunden ist. Das Bedienelement umfasst im Wesentlichen ein Display mit entsprechender Anzeigetechnik und -technologie (beispielsweise LCD-Display) und Hinterleuchtung, so dass es eine nicht unbeträchtliche Bautiefe aufweisen kann. Da der Aktuator im Idealfall allenfalls direkt unterhalb dieses Bedienelements angeordnet sein kann, greift sein Antriebselement zur aktiven Haptik-Rückmeldebewegung in Lateralbewegungsrichtung außerhalb des Massenschwerpunkts des Bedienelements bzw. des bewegten Teilsystems an dieses bzw. diesem an. Hierdurch kommt es dann ohne entsprechende Gegenmaßnahmen zwangsweise zu einer Verkippung des Bedienelements, was unerwünscht ist. Bekannte Lösungen zielen auf eine Zwangsführung mit entsprechender Auslegung des Federsystems ab, mit dem das Bedienelement am Gehäuse der Bedieneinheit gelagert ist. All dies ist mechanisch aufwendig.

Nach der Erfindung wird also für einen Ausgleich der infolge der (Vertikal- und Lateral-)Rückholfedern auf das Bedienelement wirkenden Drehmomente gesorgt, was einerseits durch die Positionierung der Rückholfedern relativ zur Wirkbewegungsachse des Antriebselements und/oder andererseits durch die Dimensionierung der Rückholfedern und/oder ferner durch "Verlagerung" des Massenschwerpunkts des Bedienelements realisiert werden kann, indem die Gewichtsverteilung des Bedienelements beeinflusst wird (durch zusätzlich angebrachte Gewichte oder durch gezielte Beeinflussung der Gewichtsverteilung). Wenn also die Bauraumsituation eine Verlagerung der Rückholfedern nicht ermöglicht, kann durch die Dimensionierung der Rückholfedern und/oder durch die Veränderung der Massenverteilung innerhalb des Bedienelements für einen Drehmomentenausgleich gesorgt werden. Somit liefert die Erfindung für sämtliche Anwendungsfälle ausreichende Freiheitsgrade für das Design. Genauer genommen muss nicht nur auf den Massenschwerpunkt des Bedienelements abgestellt werden, sondern auf den Massenschwerpunkt des bewegbaren Teilsystems der Bedieneinheit, wobei dieses bewegbare Teilsystem das Bedienelement, das Antriebselement des Aktuators mitsamt seiner Anbindung an das Bedienelement und die Rückholfedern (, die allerdings eine vernachlässigbare Masse aufweisen,) umfasst. Die gesamte für das haptische Feedback zu bewegende Masse definiert den Massenschwerpunkt, der im Rahmen der Erfindung maßgeblich für die Anordnung und/oder Dimensionierung der Rückholfedern ist, um den Drehmomentenausgleich zu realisieren. Wenn also nachfolgend von dem Massenschwerpunkt des Bedienelements die Rede ist, ist damit der Massenschwerpunkt des bewegbaren, federnd gelagerten Teilsystems gemeint, das für das haptische Feedback mechanisch angeregt ist.

In weiterer vorteilhafter Ausgestaltung der Erfindung ist vorgesehen, dass die Federwirkachsen der Rückholfedern bei Betrachtung in einer Schrägebene, die sich senkrecht zur Vertikalebene erstreckt und in der die Wirkbewegungsachse des Aktuators verläuft und/oder in der der Massenschwerpunkt des Bedienelements liegt, beidseitig der Wirkbewegungsachse des Aktuators in Abständen zu der Wirkbewegungsachse des Aktuators verlaufen, und dass die Dimensionierung der Rückholfedern hinsichtlich ihrer Federkräfte und die Abstände zur im Wesentlichen Kompensation der infolge der Rückholfedern im Massenschwerpunkt des Bedienelements wirkenden Drehmomente gewählt sind.

Die oben im Zusammenhang mit der Vertikalebenenbetrachtung vorgenommenen Überlegungen gelten ganz entsprechend auch hinsichtlich der von der Lage der Wirkbewegungsachse des Aktuators definierten Schrägebene. Auch in dieser Schrägebene, in der die Wirkbewegungsachse des Aktuators liegt (und die demzufolge von dieser Achse aufgespannt wird sowie orthogonal zur Vertikalebene verläuft), müssen wiederum die auf das bewegbare Teilsystem wirkenden, aus den Rückholfedern resultierenden Drehmomente kompensiert werden, damit es bezogen auf diese Schrägebene bzw. bezogen auf die Horizontal-Projektionsebene zu keinerlei Oszillationen kommt, wenn der Aktuator zwecks haptischem, taktilem Feedback angesteuert wird.

Ferner sieht die Erfindung vor, den Aktuator mechanisch derart ausgerichtet anzuordnen, dass die Wirkbewegungsachse des Antriebselements vorzugsweise den Massenschwerpunkt des Bedienelements schneidet. Auf der Verlängerung der Wirkbewegungsachse des Antriebselements liegt also der Massenschwerpunkt des Bedienelements. Die Wirkbewegungsachse des Antriebselements verläuft dabei also in einem spitzen Winkel zur beabsichtigten Lateralbewegungsrichtung für das aktive haptische Feedback. Indem das Bedienelement also längs der Wirkbewegungsachse des Antriebselements bewegt wird, weist die Feedbackbewegung des Bedienelements neben der beabsichtigten Lateralbewegungskomponente auch eine Vertikalbewegungskomponente auf, was aber nicht weiter störend ist. Vielmehr entscheidend ist, dass die Bedienoberfläche des Bedienelements beim aktiven haptischen Feedback ihre Ausrichtung im Raum beibehält, also eine schräg gerichtete Parallelverschiebung erfährt, und zwar ohne in Vertikal- und/oder Horizontalebene betrachtet zu oszillieren.

Durch die erfindungsgemäße Maßnahme ist es möglich, die aktive haptische Feedback-Bewegung rein translatorisch auszuführen, wobei bevorzugt die Wirkrichtung des Antriebselements durch den Massenschwerpunkt des Bedienelements verläuft.

Rotatorische Bewegungsanteile beim aktiven haptischen Feedback des Bedienelements werden weiter reduziert, indem die Rückholfederelemente, mit deren Hilfe das Bedienelement nach einem aktiven haptischen Feedback wieder in die Ausgangsposition zurück bewegt werden, in einer gemeinsamen Ebene mit dem Massenschwerpunkt des Bedienelements liegen. Wäre dies nicht der Fall, so würde das Muster der aktiven haptischen Feedbackbewegung des Bedienelements rotatorische Anteile aufweisen.

Alternativ können die Federwirkachsen auch mit der Wirkbewegungsachse des Antriebselements des Aktuators zusammenfallen; sie liegen dann auf einer gemeinsamen Linie.

Mit Vorteil wird mit der Erfindung erreicht, dass bei die infolge der Rückholfederelemente im Massenschwerpunkt des Bedienelements wirkenden Drehmomente sich gegeneinander aufheben, so dass sich das Bedienelement bei seiner Feedback-Bewegung längs der Wirkbewegungsachse des Antriebselements des Aktuators nicht zusätzlich oszillierend verdreht bzw. oszillierend verkippt.

Ferner ist es vorteilhaft, die Haptik aktiv in Hin- und Rückweg zu steuern oder zu regeln. Hierfür ist es mitentscheidend, dass die Bewegung des Bedienelements möglichst rein translatorisch ist, was durch den erfindungsgemäßen Ansatz realisierbar ist. Ferner lässt sich durch den erfindungsgemäßen Ansatz im Wesentlichen sicherstellen, dass das haptische Empfinden unabhängig vom Betätigungsort auf der Bedienoberfläche immer gleich ist. Aufwendige konstruktive Lösungen zur federnden Lagerung des Bedienelements dergestalt, dass dieses eine reine translatorische Bewegung ausführt, sind nach der Erfindung nicht mehr erforderlich.

Zweckmäßig ist es, wenn die Lateralbewegungsachse des Bedienelements und die Wirkbewegungsachse des Antriebselements des Aktuators eine gemeinsame, im Wesentlichen orthogonal zur Bedienoberfläche stehende Vertikalebene aufspannen.

In weiterer Ausgestaltung der Erfindung kann vorgesehen sein, dass das Gehäuse unterhalb des Bedienelements einen Bauraum aufweist und dass der Aktuator zur Erzielung eines kleinstmöglichen Winkels zwischen der Wirkbewegungsachse des Antriebselements des Aktuators und der Lateralbewegungsachse des Bedienelements so nah wie bauraumbedingt möglich unterhalb des Bedienelements und/oder soweit wie bauraumbedingt möglichst weit von dem Massenschwerpunkt des Bedienelements entfernt angeordnet ist. Je kleiner der Winkel zwischen der Wirkbewegungsachse des Aktuators und der Lateralbewegungsachse des Bedienelements ist, desto größer ist der Lateralbewegungsanteil des Bedienelements in Relation zum Lateralbewegungsanteil bei der Feedback-Bewegung.

Bei einer weiteren Ausgestaltung der Erfindung weist die Bedieneinheit beidseitig des Bedienelements angeordnete Rückholfederelemente für das Bedienelement mit Federwirkachsen auf, die auf der Lateralbewegungsachse liegen oder die in einer Ebene, die im Wesentlichen orthogonal zur von der Wirkbewegungsachse des Antriebselements des Aktuators und der Lateralbewegungsachse des Bedienelements aufgespannten Ebene ist, liegen sowie symmetrisch zur Lateralbewegungsachse angeordnet sind.

Ferner kann vorgesehen sein, dass der Aktuator als Zuganker-Elektromagnet mit einem ersten Stator, der eine erste Erregerspule aufweist, und mit einem Anker als Antriebselement ausgebildet ist, dass der Anker mit einer Messspule versehen ist, an der eine Messspannung anliegt, wenn der Anker von einem durch die erste Erregerspule erzeugten Magnetfluss durchdrungen wird, und dass die erste Erregerspule und die Messspule mit der Auswerte- und Ansteuereinheit verbunden sind, wobei mittels der Auswerte- und Ansteuereinheit die Kraft steuerbar und/oder regelbar ist, mit der das Antriebselement des Aktuator in Richtung auf den ersten Stator zu bewegbar ist und/oder die Auslenkbewegung des Antriebselements aus dessen Ruheposition sowie die Zurückbewegung des Antriebselements in dessen Ruheposition steuerbar und/oder regelbar ist.

Bei dieser Weiterbildung der Erfindung wird vorteilhafterweise eine relativ genaue und kostengünstige Kraftmessung in einem als Elektromagneten ausgeführten Aktuator für das haptische Feedback von Bedienelementen ermöglicht. Dabei kann der Elektromagnet als Einfach-Zuganker oder als Doppel-Zuganker ausgeführt sein. Alternativ kann der Aktuator mindestens ein piezokeramisches Element aufweisen, also piezoelektrisch arbeiten.

Aus Bauraum- und Kostengründen wird für das haptische Feedback oftmals ein Elektromagnet (Zugankermagnet) ohne Permanentmagnete als Aktuator eingesetzt. Der Stator eines derartigen Zugankermagnets ist also elektromagnetisch zu betreiben. Um die gewünschte Bewegung der Bedienoberfläche des Bedienelements einstellen zu können, muss der zeitliche Kraftverlauf am Aktuator genau einstellbar sein. Desweiteren kann es erforderlich sein, dass die Kraft, mit der das Bedienelement vor- und zurückbewegt wird, jeweils aktiv aufgebaut wird. Dies kann mittels eines Doppel-Zugankermagnets mit einem gemeinsamen Zuganker zwischen zwei elektromagnetischen Statoren realisiert werden.

Die Kraft eines Elektromagneten hängt bei langsam veränderlichen Magnetfeldern im Wesentlichen vom Ankerstrom und vom Luftspalt zwischen Zuganker und Stator ab. Der Kraftverlauf im Falle des haptischen Feedbacks ist jedoch sehr dynamisch und umfasst Frequenzanteile oberhalb von 1 kHz. Hierbei ist der Zusammenhang zwischen Strom und Kraft bei üblich verwendeten Automatenstählen oder Elektroblechen zur Magnetflussführung nicht trivial und nur durch eine sehr aufwendige Modellierung beschreibbar. Hinzu kommt noch, dass der Luftspalt wegen der mechanischen Toleranzen und der Bewegung der Bedienoberfläche nicht genau bekannt ist, weshalb die Kraftwirkung eines Zugankermagnets nur grob abschätzbar ist.

Mit dem hier beschriebenen Ansatz der Messung des den Zuganker durchziehenden Magnetflusses mittels einer Messspule und der an dieser abfallenden induzierten Spannung lässt sich nun die Kraft und die Bewegung des Zugankers steuern bzw. regeln. Auch lässt sich nun die Bewegung des Zugankers gezielt dämpfen, so dass ein Überschwingen in der jeweiligen Endlage der Vor- und Zurückbewegung des Zugankers vermieden werden kann.

Wie bereits oben dargelegt, ist es von weiterem Vorteil, wenn der Zuganker zwischen zwei elektromagnetisch betriebenen Statoren angeordnet ist. Bei dieser Ausführungsform der Erfindung weist der Zuganker also einen zweiten Stator mit einer zweiten Erregerspule auf, wobei die beiden Statoren beidseitig des Ankers angeordnet sind und auch die zweite Erregerspule mit der Auswerte- und Ansteuereinheit verbunden ist, wobei mittels der Auswerte- und Ansteuereinheit die jeweilige Kraft, mit der das Antriebselement in die jeweilige Richtung auf den ersten bzw. zweiten Stator zu bewegbar ist, und/oder die Auslenkbewegung des Antriebselements aus dessen Ruheposition sowie die Zurückbewegung des Antriebselements in dessen Ruheposition steuerbar und/oder regelbar ist.

Die Erfindung wird nachfolgend anhand eines Ausführungsbeispiels und unter Bezugnahme auf die Zeichnung näher erläutert. Im Einzelnen zeigen:

Fig. 1        schematisch und in Seitenansicht eine Bedieneinheit für eine Fahrzeugkomponente mit als Displayelement ausgeführtem Bedienelement und federelastischer Lagerung sowie aktivem haptischen Feedback zur Betätigung des Bedienelements,

Fig. 2        eine Darstellung eines Elektromagneten, ausgebildet als Zugankermagnet mit Stator und Anker zur grundsätzlichen Erläuterung der elektromagnetisch relevanten Eigenschaften eines derartigen Elektromagneten,

Fig. 3        eine perspektivische Darstellung des als Doppelelektromagnet ausgebildeten Aktuators für die aktive haptische Rückmeldung,

Fig. 4        eine mögliche Beschaltung des Elektromagneten gemäß Fig. 3 und

Fign. 5 bis 8   verschiedene Ausgestaltungen der Anordnung und Beschaffenheit der Rückholfedern (sowohl in der Vertikal- als auch in der Horizontalbzw. Schrägebene) zur Zurückbewegung des mit aktivem Feedback ausgestatteten Bedienelements, so dass sich auf dessen Massenschwerpunkt wirkende Drehmomente, die ein Oszillieren des Bedienelements um dessen Massenschwerpunkt hervorrufen würden, gegeneinander aufheben.

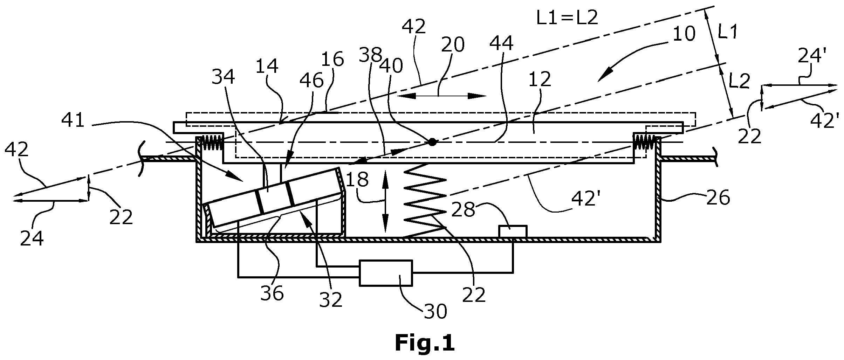

In Fig. 1 ist in Seitenansicht und schematisch eine Bedieneinheit 10 gezeigt, die ein Bedienelement 12 aufweist. Das Bedienelement 12 ist in diesem Ausführungsbeispiel als Display-Baugruppe mit einer Bedienoberfläche 14 ausgeführt, auf der eine Vielzahl von Symbolfeldern 16 darstellbar ist. Das Bedienelement 12 ist im Regelfall hinterleuchtet.

Zur Ausführung einer Betätigungsbewegung in Vertikalbewegungsrichtung (siehe den Doppelpfeil 18) sowie zur Bestätigung einer derartigen Betätigungsbewegung in lateraler Richtung (siehe den Doppelpfeil 20 in Fig. 1) ist das Bedienelement 12 über erste Rückholfedern 22 sowie zweite Rückholfedern 24,24' elastisch an einem Gehäuse 26 gelagert. Mittels eines Sensors 28 lässt sich feststellen, dass sich das Bedienelement längs der Vertikalbewegungsachse 18 bewegt hat. Dies wird in einer Auswerte- und Ansteuereinheit 30 ermittelt, woraufhin diese einen als Elektromagneten ausgeführten Aktuator 32 ansteuert, der ein Antriebselement 34 aufweist. Der feststehende Statorteil 36 des Aktuators 32 stützt sich am Gehäuse 26 ab, während das Antriebselement 34 des Aktuators 32 mechanisch mit dem Bedienelement 12 gekoppelt ist. Die Wirkbewegungsachse des Antriebselements 34 ist anhand des Doppelpfeils 38 dargestellt.

Je größer und aufwendiger das Bedienelement 12 konstruiert ist, umso schwerer ist es und umso mehr Bauraum nimmt es ein. Wenn nun gefordert wird, dass das haptische Feedback über die gesamte Bedienoberfläche 14 betrachtet gleich sein soll, so sollte das Bedienelement 12 beim haptischen Feedback ausschließlich eine translatorische Bewegung vollführen. Theoretisch gelingt dies in einfachster Weise dadurch, dass das Antriebselement 34 des Aktuators 32 im Massenschwerpunkt 40 des Bedienelements 12 oder, genauer gesagt im Massenschwerpunkt des bewegbaren, elastisch gelagerten Teilsystems angreift. Dies ist aber aufgrund der Bauraumgegebenheiten nicht möglich.

Will man nun dennoch erreichen, dass sich das Bedienelement 12 beim aktiven haptischen Feedback ausschließlich translatorisch bewegt, so besteht eine konstruktiv vergleichsweise einfache Lösung darin, den Aktuator 32 derart anzuordnen, dass der Massenschwerpunkt 40 des bewegbaren Teilsystems 41 aus Bedienelement 12, Antriebselement 34 des Aktuators 32 und den Massen sämtlicher Rückholfedern 22,24,24' auf der Wirkbewegungsachse 38 des Antriebselements 34 des Aktuators 32 liegt. Dies ist in Fig. 1 gezeigt, wobei in Fig. 1 auch dargestellt ist, wie sich das Bedienelement 12 aktiv bewegt, wenn eine Betätigungsbewegung erkannt und die Betätigung des Bedienelements 12 durch haptisches Feedback rückbestätigt wird.

Im Wesentlichen orthogonal zu dieser Ebene 44 verläuft diejenige Ebene, die durch die Lateralbewegungsachse 20 des Bedienelements 12 und die Wirkbewegungsachse 38 des Antriebselements 34 des Aktuators 32 aufgespannt wird. Bei dieser Ebene handelt es sich bezogen auf Fig. 1 um die Zeichnungsebene.

Die rein translatorische Bewegung des Bedienelements 12 beim aktiven haptischen Feedback weist also sowohl eine Lateral- als auch eine Vertikalkomponente auf. Dass diese Feedbackbewegung nicht rein lateral ist, spielt dafür, dass das haptische Empfinden über die gesamte Bedienoberfläche 14 des Bedienelements 12 gleich sein soll, keine Rolle. Entscheidend ist, dass das Bedienelement 12 beim aktiven haptischen Feedback keinerlei rotatorische Bewegungsanteile erfährt, es also insoweit zu einer Parallelverschiebung des Bedienelements 12 im Raum kommt.

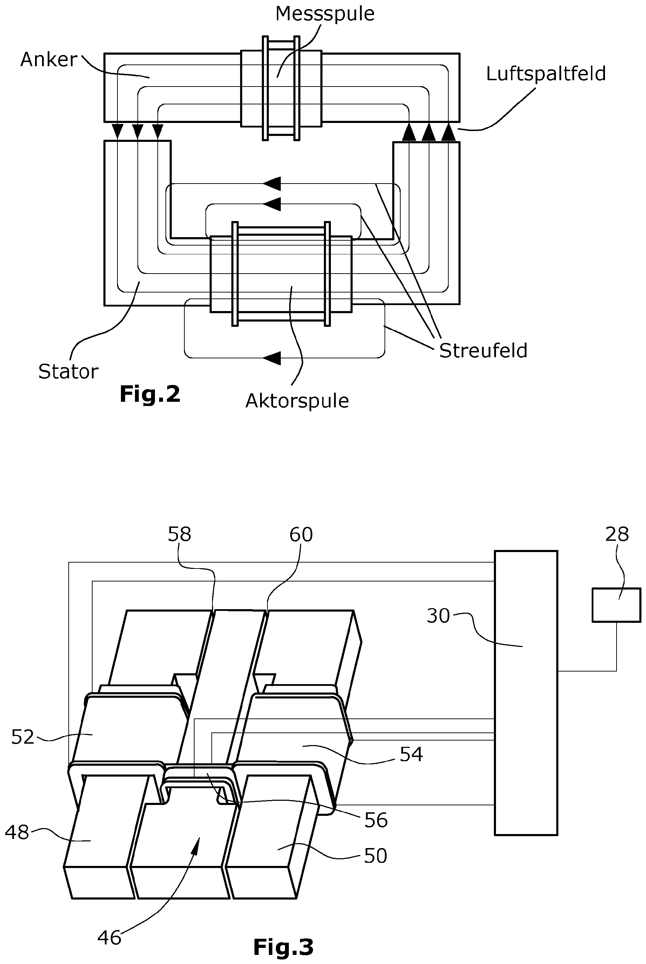

Wie bereits weiter oben beschrieben, setzt man aus insbesondere Bauraum- und Kostengründen für das haptische Feedback von Bedienelementen oftmals als Aktuator einen Elektromagneten ein. Die von diesem Elektromagneten aufgebrachte Kraft kann nur mit erhöhtem Aufwand abgeschätzt werden und hängt ganz wesentlich vom Strom und Luftspalt des Elektromagneten ab. Die insoweit geltenden Gegebenheiten bei einem Elektromagneten sollen nachfolgend anhand von Fig. 2 verdeutlicht werden.

In Fig. 2 ist ein Elektromagnet dargestellt, dessen Stator und Anker aus hochpermeablen Materialien (üblicherweise Automatenstahl oder Elektroblech) besteht, und dessen Magnetfeld mittels einer bestromten Erregerspule aufgebaut wird.

Die Kraft eines solchen Elektromagneten wird üblicherweise aus dem Erregerstrom und der Luftspaltgröße berechnet. Der Kraftverlauf im Falle des haptischen Feedbacks ist jedoch sehr dynamisch mit Frequenzanteilen oberhalb von 1 kHz. Hierbei ist der Zusammenhang zwischen Strom und Kraft bei üblich verwendeten Automatenstählen oder Elektroblechen zur Magnetflussführung nicht trivial und nur durch eine sehr aufwendige Modellierung beschreibbar. Dazu kommt noch, dass der Luftspalt wegen der mechanischen Toleranzen und der Bewegung der Bedienoberfläche nicht genau bekannt ist, und somit die Kraftwirkung des Aktuators nur grob abschätzbar ist. Unter Verwendung der "Maxwellschen Zugkraftformel" und einer Messspule zur Ermittlung der magnetischen Flussdichte im Luftspalt kann dieses Problem umgangen werden, wobei eine Spannungsmessung in aller Regel kostengünstiger gestaltet werden kann als eine Strommessung:

$$F = \frac{B_L^2 A_L}{2\mu_0}$$

*(F* - Aktuatorkraft, $\mu_0$ - Permeabilität der Luft, $A_L$ - Luftspaltfläche, $B_L$ - Magnetflussdichte im Luftspalt)

Die relativ geringe Inhomogenität der Luftspaltflussdichte in praktischen Ausführungen kann durch einen Korrekturfaktor berücksichtigt werden, was wiederum zu einer einfachen Realisierung einer Kraftmessung mittels einer Messspule führt:

$$F(t) = \frac{C}{\mu_0 A_L} \left( \frac{1}{N_{MS}} \int_0^t u(t')dt' \right)^2$$

*(t* - Zeit, *C* - Luftspaltkorrekturfaktor, $N_{MS}$ - Windungszahl der Messpule, *u(t)* - induzierte Spannung in der Messspule)

Die Integration der induzierten Spannung kann digital mit einem in der Regel im System schon vorhandenen Mikrocontroller ausgeführt werden. Somit ist die Kraft zu jedem Zeitpunkt der Ansteuerung bekannt.

Fig. 3 zeigt den Aktuator 32 in perspektivischer Ansicht. Dieser Aktuator 32 ist als Doppelelektromagnet ausgebildet, dessen Antriebselement 34 als Anker 46, der zwischen einem ersten Stator 48 und einem zweiten Stator 50 angeordnet ist, in zwei entgegengesetzten Richtungen längs der Wirkbewegungsachse 38 Kraft aufbauen kann.

Der erste und der zweite Stator 48, 50 sind am Gehäuse 26 befestigt, während der Anker 46 mit dem Bedienelement 12 fest verbunden ist. Der erste Stator 48 weist eine erste Erregerspule 52 auf, während der zweite Stator 50 mit einer zweiten Erregerspule 54 versehen ist. Der Anker 46 ist von einer Messspule 56 umgeben. Beidseitig des Ankers 46 befindet sich jeweils ein erster bzw. ein zweiter Luftspalt 58, 60. Da die auf den Anker 46 wirkende Kraft jeweils in eine Richtung gerichtet sein soll, werden die Erregerspulen 52, 54 entsprechend nicht gleichzeitig, sondern abwechselnd bestromt. Mit dem Aufbau der Messspule 56 am Anker 46 wird eine genaue und kostengünstige Kraftmessung in beiden Wirkrichtungen längs der Wirkbewegungsachse 38 ermöglicht.

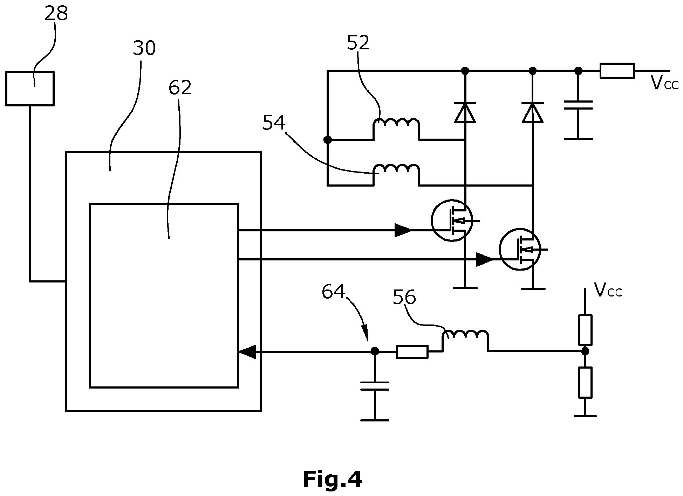

Die Ansteuerung und die Auswertung der in der Messspule 56 induzierten Spannung können beispielhaft mittels eines Mikrocontrollers 62 erfolgen, der Teil der Auswerte- und Ansteuereinheit 30 sein kann. Ein Beispiel für eine Beschaltung mit dem Mikrocontroller 62 ist in Fig. 4 gezeigt. Die induzierte Spannung in der Messspule 56 wird zunächst durch einen einfachen Tiefpass 64 geglättet, um die PWM-Taktung (Frequenz in der Regel > 20 kHz) zur wechselweisen Ansteuerung der beiden Erregerspulen 52, 54 aus dem Messsignal zu eliminieren. Danach erfasst der Mikrocontroller 62 die induzierte Spannung und integriert sie digital. Die Grenzfrequenz des Tiefpasses 64 sollte ausreichend höher als die höchsten Frequenzanteile des Kraftverlaufs liegen.

Im Zusammenhang mit der Fig. 1 ist weiter oben bereits beschrieben, dass die Rückholfedern 22,24,24' so angeordnet sind, dass ihre jeweiligen resultierenden Federwirkachsen 42,42' parallel zur durch den Massenschwerpunkt 40 verlaufenden Wirkbewegungsachse 38 des Aktuators 32 verlaufen. Damit es bei der durch die Rückholfedern 22,24,24' induzierten Bewegung des Bedienelements 12 nicht zu Rotationen desselben kommt (und zwar sowohl um eine horizontal als auch vertikal durch den Massenschwerpunkt 40 des Bedienelements 12 verlaufenden Achse), sollte die Summe der durch die Rückholfedern 22,24,24' im Massenschwerpunkt 40 verursachten Drehmomente null sein. Dazu sollten die resultierenden Federwirkachsen 42,42' z.B. parallel zueinander und zur Wirkbewegungsachse 38 verlaufen (siehe auch die Federkräftedreiecke der Rückholfedern 22,24,24' in Fig. 1).

Bei gänzlich symmetrischer Anordnung von Massenschwerpunkt 40, und Rückholfedern 22,24,24' (bzw. Angriffspunkten der Rückholfedern 24,24' am Bedienelement 12) mit gleichen Kennlinien der (Vertikal-)Rückholfedern 22 und gleichen Kennlinien der (Lateral-)Rückholfedern 24,24' wirken somit im Massenschwerpunkt 40 keine durch sämtliche Rückholfedern 22,24,24' hervorgerufene Drehmomente auf das Bedienelement 12 (siehe Fig. 1, wonach die Abstände L1 und L2 gleich sind). Derartige Einbau- bzw. Anordnungsverhältnisse sind aber nicht immer zu erreichen. Sollten z.B. die Rückholfedern 24,24' asymmetrisch angeordnet sein (,und zwar in horizontaler und/oder in vertikaler Ebene), so entstehen infolge der Hebelarme, d.h. der Abstände der parallel zur Wirkbewegungsachse 38 des Aktuators 32 verlaufenden resultierenden Federwirkachsen 42,42' der Rückholfedern 22 und 24 bzw. 22 und 24' zum Massenschwerpunkt 40 (bzw. der Wirkbewegungsachse 38), Drehmomente im Massenschwerpunkt 40. Diese müssen sich gegeneinander aufheben, so dass das Bedienelement 12 bei der haptischen Feedback-Bewegung nicht um den Massenschwerpunkt 40 rotatorisch oszilliert.

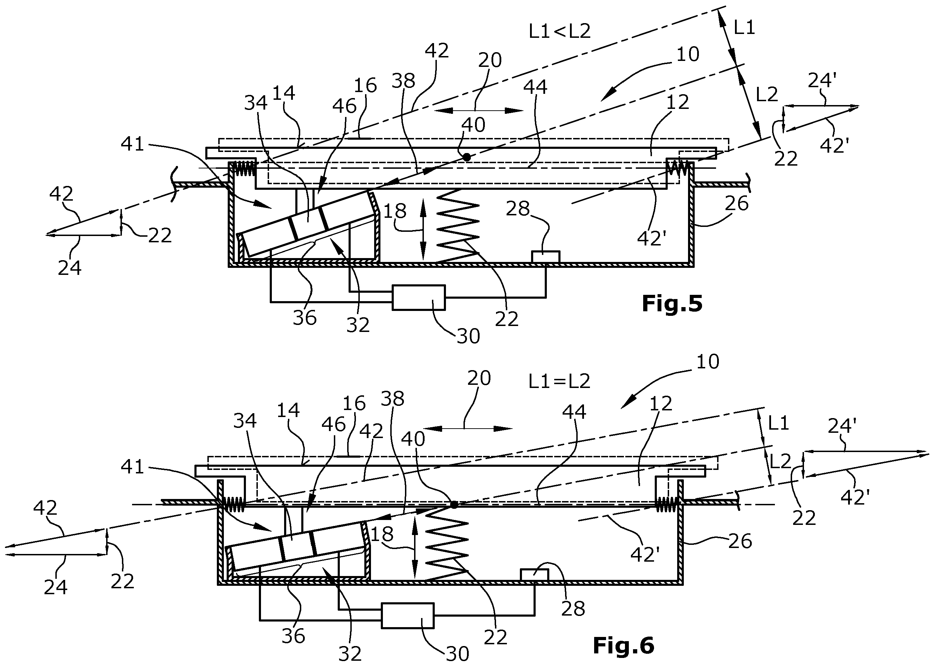

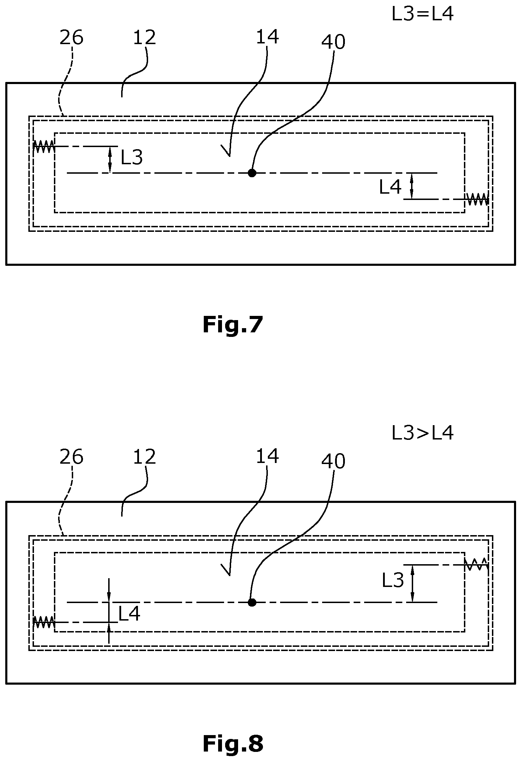

Die Fign. 5 bis 8 zeigen verschiedene Szenarien, in denen in Abhängigkeit von der Lage des Massenschwerpunkts 40 durch Anordnung der Rückholfedern 22,24,24' (Lage der Angriffspunkte der Rückholfedern 22,24,24' an dem Bedienelement 12) und/oder deren Elastizität (angedeutet durch die Dichte der Windungen, wobei eine dichte Windung eine weniger elastische, also steifere Feder symbolisiert als eine weniger dichte Windung) eine Oszillation des bewegbaren Teilsystems 41 um dessen Massenschwerpunkt 40 verhindert/ vermindert werden kann, und zwar sowohl in vertikaler Ebene (siehe Fign. 5 und 6) als auch in horizontaler Ebene (siehe Δh die Fign. 7 und 8). Der Ausgleich der Drehmomente der beidseitig des Teilsystems 41 wirkenden Rückholfedern 22,24,24' kann durch die Wahl der Vertikal- und Horizontalpositionen (siehe Fign. 6 und 7) und/oder durch die Wahl der Federkräfte (siehe Fign. 5 und 8) erzielt werden. Schließlich kann der Drehmomentausgleich ggf. zusätzlich auch durch die Beeinflussung des Massenschwerpunkts des bewegbaren mechanisch angeregten Teilsystems 41 erzielt werden (z. B. Vorsehen von Zusatzgewichten, Beeinflussung der Massenverteilung etc.)

Die zuvor genannten Randbedingungen dahingehend, dass sich sämtliche im Massenschwerpunkt 40 des Teilsystems 41 wirkende Drehmomente gegeneinander aufheben, können als zweidimensionales Problem (Vertikal- und Horizontal-Ebene-) aufgefasst werden.

Es kann erforderlich sein, z.B. zwei Paare von Rückholfedern 24,24' vorzusehen, um eine ungewollte Oszillation des Bedienelements 12 um zwei senkrecht aufeinander stehende Rotationsachsen (horizontal und vertikal) durch den Massenschwerpunkt 40 unterdrücken bzw. vermindern zu können. Die elastische Anbindung des Bedienelements 12 an das Gehäuse 26 erfolgt vorzugsweise mittels des Halterahmens, wie es in WO-A-2017/129 557 beschrieben ist. Dabei kann durch z.B. die Dicke der beiden in WO-A-2017/129 557 beschriebenen Lateral-Federarme (,die die Funktion der Rückholfedern 22,24,24' realisieren,) und/oder deren Querschnittsformen und/oder deren Längen und/oder deren Höhenpositionen Einfluss auf die auf das Bedienelement 12 wirkenden Drehmomente genommen werden.

Ein "verstimmtes" System kann durch eine der folgenden Maßnahmen optimiert werden:

- die Rückholfedern werden hinsichtlich ihrer Wirkachsen relativ zur Aktuator-Wirkachse verschoben,
- der Massenschwerpunkt wird (durch zusätzliche Gewichte bzw. Änderung der geometrischen Form des Bedienelements) verschoben,
- die in Normalrichtung wirkenden Federkräfte der Rückholfedern können von Rückholfeder zu Rückholfeder unterschiedlich sein.

**BEZUGSZEICHENLISTE**

| 10 | Bedieneinheit |
|---|---|
| 12 | Bedienelement |
| 14 | Bedienoberfläche des Bedienelements |
| 16 | Symbolfelder |
| 18 | Vertikalbewegungsachse des Bedienelements |
| 20 | Lateralbewegungsachse des Bedienelements |
| 22 | (Vertikal-)Rückholfeder |
| 24 | (Lateral-)Rückholfeder |
| 24' | (Lateral-)Rückholfeder |
| 26 | Gehäuse |
| 28 | Sensor |
| 30 | Ansteuereinheit |
| 32 | Aktuator |
| 34 | Antriebselement des Aktuators |
| 36 | Statorteil des Aktuators |
| 38 | Wirkbewegungsachse des Aktuators |
| 40 | Massenschwerpunkt des bewegbaren Teilsystems |
| 41 | bewegbares Teilsystem |
| 42 | resultierende Federwirkachse der Rückholfedern 24 und 22 |
| 42' | resultierende Federwirksachse der Rückholfedern 24' und 22 |
| 44 | Ebene |
| 46 | Anker |
| 48 | Stator |
| 50 | Stator |

| | |
|---|---|
| 52 | Erregerspule |
| 54 | Erregerspule |
| 56 | Messspule |
| 58 | Luftspalt |
| 60 | Luftspalt |
| 62 | Mikrocontroller |
| 64 | Tiefpass |
| L1 | (erster) Abstand der resultierenden Wirkachse der Rückholfedern 22,24 zur Wirkbewegungsachse 38 des Aktuators 32 (in der Vertikalebene betrachtet) |
| L2 | (zweiter) Abstand der resultierenden Wirkachse der Rückholfedern 22,24' zur Wirkbewegungsachse 38 des Aktuators 32 (in der Vertikalebene betrachtet) |
| L3 | (dritter) Abstand der resultierenden Wirkachse der Rückholfedern 22,24 zur Wirkbewegungsachse 38 des Aktuators 32 (in der von der Wirkbewegungsachse aufgespannten Schrägebene betrachtet) |
| L4 | (vierter) Abstand der resultierenden Wirkachse der Rückholfedern 22,24' zur Wirkbewegungsachse 38 des Aktuators 32 (in der von der Wirkbewegungsachse aufgespannten Schrägebene betrachtet) |

**Patentansprüche**

1. Bedieneinheit für ein Fahrzeug, insbesondere Infotainment-System zur Steuerung diverser Fahrzeugkomponenten, mit

   - einem Gehäuse (26) mit einer Vorderseite
   - einem an der Vorderseite des Gehäuses (26) angeordneten Bedienelement (12), das eine Bedienoberfläche (14) aufweist,
   - wobei das Bedienelement (12) an und/oder in dem Gehäuse (26) längs einer zur Bedienoberfläche (14) im Wesentlichen orthogonal verlaufenden Vertikalbewegungsachse (18) und längs einer im Wesentlichen quer dazu verlaufenden Lateralbewegungsachse (20) elastisch gelagert ist,
   - mindestens einem Sensor (28) zur Erfassung einer Betätigungsbewegung des Bedienelements (12) in Richtung der Vertikalbewegungsachse (18),
   - einem in und/oder an dem Gehäuse (26) angeordneten Aktuator (32) zur Rückmeldebewegung des Bedienelements (12) zumindest auch in der Lateralbewegungsachse (20) bei einer erkannten Betätigungsbewegung des Bedienelements (12), wobei der Aktuator (32) ein elektrisch ansteuerbares, mit dem Bedienelement (12) mechanisch gekoppeltes Antriebselement (34) aufweist, das längs einer Wirkbewegungsachse (38) vor- und zurückbewegbar ist, und

   - einer Auswerte- und Ansteuereinheit (30), die mit dem Sensor (28) und dem Aktuator (32) verbunden ist,

   **dadurch gekennzeichnet,**

   - **dass** das Bedienelement (12) mittels Rückholfedern (22,24,24') gelagert ist,
   - **dass** die Rückholfedern (22,24,24') resultierende Federwirkachsen (42,42') aufweisen, die parallel zur Wirkbewegungsachse (38) des Aktuators (32) verlaufen,
   - **dass** die Federwirkachsen (42,42') der Rückholfedern (24,24') bei Betrachtung in der Vertikalebene, in der die Wirkbewegungsachse (38) des Aktuators (32) verläuft und/oder in der der Massenschwerpunkt (40) des Bedienelements (12) oder des bewegbaren Teilsystems (41) aus u.a. dem Bedienelement (12) und dem mit diesem gekoppelten Antriebselement (34) des Aktuators (32) liegt, beidseitig der Wirkbewegungsachse (38) des Aktuators (32) in einem ersten Abstand (L1) bzw. einem zweiten Abstand (L2) zu der Wirkbewegungsachse (38) des Aktuators (32) verlaufen und
   - **dass** die Dimensionierung der Rückholfedern (22,24,24') hinsichtlich ihrer Federkräfte und die Dimensionierung des ersten sowie des zweiten Abstands (L1,L2) zur im Wesentlichen Kompensation der infolge der Rückholfedern (22,24,24') im Massenschwerpunkt (40) des Bedienelements (12) oder des bewegbaren Teilsystems (41) wirkenden Drehmomente gewählt sind.

2. Bedieneinheit nach Anspruch 1, **dadurch gekennzeichnet, dass** die Federwirkachsen (42,42') der Rückholfedern (22,24,24') bei Betrachtung in einer Schrägebene, die sich senkrecht zur Vertikalebene erstreckt und in der die Wirkbewegungsachse (38) des Aktuators (32) verläuft und/oder in der der Massenschwerpunkt (40) des Bedienelements (12) oder des bewegbaren Teilsystems (41) liegt, beidseitig der Wirkbewegungsachse (38) des Aktuators (32) in einem dritten Abstand (L3) bzw. einem vierten Abstand (L4) zu der Wirkbewegungsachse (38) des Aktuators (32) verlaufen und dass die Dimensionierung der Rückholfedern (22,24,24') hinsichtlich ihrer Federkräfte und die Dimensionierung des dritten und des vierten Abstands (L3,L4) zur im Wesentlichen Kompensation der infolge der Rückholfedern (22,24,24') im Massenschwerpunkt (40) des Bedienelements (12) oder des bewegbaren Teilsystems (41) wirkenden Drehmomente gewählt sind.

3. Bedieneinheit nach Anspruch 1 oder 2, **dadurch gekennzeichnet, dass** der Massenschwerpunkt (40) des Bedienelements (12) oder des bewegbaren Teilsystems (41) auf der Wirkbewegungsachse (38) des Antriebselements (34) des Aktuators (32) liegt.

4. Bedieneinheit nach einem der Ansprüche 1 bis 3, **dadurch gekennzeichnet, dass** die Lateralbewegungsachse (20) des Bedienelements (12) und die Wirkbewegungsachse (38) des Antriebselements (34) des Aktuators (32) in eine gemeinsame, im Wesentlichen orthogonal zur Bedienoberfläche (14) stehende Vertikalebene liegen.

5. Bedieneinheit nach Anspruch 4, **dadurch gekennzeichnet, dass** das Gehäuse (26) unterhalb des Bedienelements (12) einen Bauraum aufweist und dass der Aktuator (32) zur Erzielung eines kleinstmöglichen Winkels zwischen der Wirkbewegungsachse (38) des Antriebselements (34) des Aktuators (32) und der Lateralbewegungsachse (20) des Bedienelements (12) so nah wie bauraumbedingt möglich unterhalb des Bedienelements (12) und/oder soweit wie bauraumbedingt möglich weit von dem Massenschwerpunkt (40) des Bedienelements (12) entfernt angeordnet ist.

6. Bedieneinheit nach einem der Ansprüche 1 bis 5, **dadurch gekennzeichnet, dass** die Federwirkachsen (42,42') auf der Lateralbewegungsachse (20) oder auf der Wirkbewegungsachse (38) des Antriebselements (34) des Aktuators (32) liegen oder in einer Ebene (44) liegen, die im Wesentlichen orthogonal zu einer Vertikalebene verläuft, in der die Wirkbewegungsachse (38) des Antriebselements (34) des Aktuators (32) und die Lateralbewegungsachse (20) des Bedienelements (12) liegen, sowie symmetrisch zur Lateralbewegungsachse (20) angeordnet sind.

7. Bedieneinheit nach einem der Ansprüche 1 bis 5, **dadurch gekennzeichnet, dass** die infolge der Rückholfedern (22,24,24') im Massenschwerpunkt (40) des Bedienelements (12) oder des Teilsystems (41) wirkenden Drehmomente sich gegeneinander aufheben, so dass das Bedienelement (12) bei seiner Feedback-Bewegung längs der Wirkbewegungsachse (38) des Antriebselements (34) des Aktuators (32) sich nicht zusätzlich verdreht bzw. nicht verkippt.

## Claims

1. An operating unit for a vehicle, particularly an infotainment system for control of diverse vehicle components, comprising

   - a housing (26) having a front side,
   - an operating element (12) arranged on the front side of the housing (26) and comprising an operating interface (14),

   - wherein the operating element (12) is mounted in a spring-elastic manner on and/or in the housing (26) along a vertical axis of movement (18) extending substantially orthogonally with respect to the operating surface (14) and along a lateral axis of movement (20) extending substantially transversely with respect to the vertical axis of movement,
   - at least one sensor (28) for detecting an actuating movement of the operating element (12) in the direction of the vertical axis of movement (18),
   - an actuator (32), arranged in and/or on the housing (26), for feedback movement of the operating element (12) at least also in the lateral axis (20) of movement when an actuation movement of the operating element (12) is detected, wherein the actuator (32) has an electrically activated drive element (34) which is mechanically coupled to the operating element (12) and can be moved forward and backward along an axis (38) of effective movement, and
   - an evaluating and control unit (30) which is connected to the sensor (28) and the actuator (32),

   **characterized in**

   - the operating element (12) is mounted by means of return springs (22,24,24'),
   - that the return springs (22,24,24') have resultant spring effect axes (42,42') which extend parallel to the axis (38) of effective movement of the actuator (32),
   - that the spring effect axes (42,42') of the return springs (24,24'), when viewed in the vertical plane in which the axis (38) of effective movement of the actuator (32) extends and/or in which the center of mass (40) of the operating element (12) or of the movable partial system (41) including inter alia the operating element (12) and the drive element (34), coupled thereto, of the actuator (32) is situated, extend on both sides of the axis (38) of effective movement of the actuator (32) at a first distance (L1) and respectively a second distance (L2) to the axis (38) of effective movement of the actuator (32), and
   - that the dimensioning of the return springs (22,24,24') with respect to their spring forces and the dimensioning of the first and the second distance (L1,L2) are selected to substantially compensate for the moments of rotation acting as a result of the return springs (22,24,24') in the center of mass (40) of the operating element (12) or of the movable partial system (41).

2. The operating unit according to claim 1, **characterized in that** the spring effect axes (42,42') of the return springs (22,24,24'), when viewed in an oblique plane which extends vertically to the vertical plane and in which the axis (38) of effective movement of the actuator (32) extends and/or in which the center of mass (40) of the operating element (12) or of the movable partial system (41) is situated, extends on both sides of the axis (38) of effective movement of the actuator (32) at a third distance (L3) and respectively a fourth distance (L4) to the axis (38) of effective movement of the actuator (32), and that the dimensioning of the return springs (22,24,24') with respect to their spring forces and the dimensioning of the third and the fourth distance (L3,L4) are selected to substantially compensate for the moments of rotation acting as a result of the return springs (22,24,24') in the center of mass (40) of the operating element (12) or of the movable partial system (41).

3. The operating unit according to claim 1 or 2, **characterized in that** the center of mass (40) of the operating element (12) or of the movable partial system (41) is situated on the axis (38) of effective movement of the drive element (34) of the actuator (32).

4. The operating unit according to any one of claims 1 to 3, **characterized in that** the axis (20) of lateral movement of the operating element (12) and the axis (38) of effective movement of the drive element (34) of the actuator (32) are situated in a common vertical plane extending substantially orthogonally to the operating surface (14).

5. The operating unit according to claim 4, **characterized in that** the housing (26) below the operating element (12) comprises an installation space, and that the actuator (32), for obtaining the smallest possible angle between the axis (38) of effective movement of the drive element (34) of the actuator (32) and the axis (20) of lateral movement of the operating element (12), is arranged as closely below the operating element (12) as possible with regard to the installation space and/or as far away from the center of mass (40) of the operating element (12) as possible with regard to the installation space.

6. The operating unit according to any one of claims 1 to 5, **characterized in that** the spring effect axes (42,42') are arranged on the axis (20) of lateral movement or on the axis (38) of effective movement of the drive element (34) of the actuator (32), or in a plane (44) that is substantially orthogonal to a vertical plane in which the axis (38) of effective movement of the drive element (34) of the actuator (32) and the axis (20) of lateral movement of the operating element (12) are situated, and symmetrically to the axis (20) of lateral movement.

7. The operating unit according to any one of claims 1 to 5, **characterized in that** the moments of rotation acting as a result of the return springs (22,24,24') in the center of mass (40) of the operating element (12) or of the partial system will neutralize each other so that the operating element (12) during its feedback movement along the axis (38) of effective movement of the drive element (34) of the actuator (32) will not additionally twist or tilt.

## Revendications

1. Unité de commande pour un véhicule, en particulier système d'info-divertissement, pour le pilotage de divers composants du véhicule, dotée

    - d'un boîtier (26) doté d'une face avant
    - d'un élément de commande (12) agencé sur la face avant du boîtier (26), laquelle comporte une surface de commande (14),
    - dans laquelle l'élément de commande (12) est disposé de manière élastique sur et/ou dans le boîtier (26) le long d'un axe de mouvement vertical (18) s'étendant essentiellement orthogonal à la surface de commande (14) et le long d'un axe de mouvement latéral (20) s'étendant essentiellement transversal à celle-ci,
    - d'au moins un capteur (28) pour saisir un mouvement d'actionnement de l'élément de commande (12) dans la direction de l'axe de mouvement vertical (18),
    - d'un actionneur (32) agencé dans et/ou sur le boîtier (26) pour un mouvement de rétroaction de l'élément de commande (12) au moins également dans l'axe de mouvement latéral (20) lors d'un mouvement d'actionnement connu de l'élément de commande (12), dans laquelle l'actionneur (32) comporte un élément d'entraînement (34) électriquement pilotable et couplé mécaniquement à l'élément de commande (12), lequel peut être avancé et reculé le long d'un axe de mouvement opérant (38), et
    - d'une unité de contrôle et de pilotage (30), laquelle est raccordée au capteur (28) et à l'actionneur (32),
    - **caractérisée en ce que**
    - l'élément de commande (12) est disposé au moyen de ressorts de maintien (22, 24, 24'), **en ce que**
    - les ressorts de maintien (22, 24, 24') présentent des axes actifs de ressort (42, 42') résultants qui sont parallèles à l'axe de mouvement actif (38) de l'actionneur (32), **en ce que**
    - les axes actifs de ressort (42, 42') des ressorts de maintien (24, 24') sont, en vue dans le plan vertical où est situé l'axe de mouvement actif (38) de l'actionneur (32) et/ou où est situé le centre de gravité (40) de l'élément de commande (12) ou du sous-système mobile (41) formé par, entre autres, l'élément de commande (12) et l'élément d'entraînement (34) couplé à celui-ci de l'actionneur (32), situés des deux côtés de l'axe de mouvement actif (38) de l'actionneur (32) dans un premier écart (L1) ou un deuxième écart (L2) par rapport à l'axe de mouvement actif (38) de l'actionneur (32) et **en ce que**

- le dimensionnement des ressorts de maintien (22, 24, 24') en ce qui concerne leurs forces de ressort et le dimensionnement du premier et du deuxième écart (L1, L2) sont choisis afin de compenser sensiblement les couples résultant des ressorts de maintien (22, 24, 24') opérant dans le centre de gravité (40) de l'élément de commande (12) ou du sous-système mobile (41).

2. Unité de commande selon la revendication 1, **caractérisée en ce que** les axes actifs de ressort (42, 42') des ressorts de maintien (22, 24, 24') sont, en vue dans un plan oblique perpendiculaire au plan vertical et où s'étend l'axe de mouvement actif (38) de l'actionneur (32) et/ou où est situé le centre de gravité (40) de l'élément de commande (12) ou du sous-système mobile (41), situés des deux côtés de l'axe de mouvement actif (38) de l'actionneur (32) dans un troisième écart (L3) ou un quatrième écart (L4) par rapport à l'axe de mouvement actif (38) de l'actionneur (32) et **en ce que** le dimensionnement des ressorts de maintien (22, 24, 24') en ce qui concerne leurs forces de ressort et le dimensionnement du troisième et du quatrième écart (L3, L4) sont choisis afin de compenser sensiblement les couples résultant des ressorts de maintien (22, 24, 24') opérant dans le centre de gravité (40) de l'élément de commande (12) ou du sous-système mobile (41).

3. Unité de commande selon la revendication 1 ou 2, **caractérisée en ce que** le centre de gravité (40) de l'élément de commande (12) ou du sous-système mobile (41) se trouve sur l'axe de mouvement actif (38) de l'élément d'entraînement (34) de l'actionneur (32).

4. Unité de commande selon l'une des revendications 1 à 3, **caractérisée en ce que** l'axe de mouvement latéral (20) de l'élément de commande (12) et l'axe de mouvement actif (38) de l'élément d'entraînement (34) de l'actionneur (32) se trouvent dans un plan vertical commun, essentiellement orthogonal à la surface de commande (14).

5. Unité de commande selon la revendication 4, **caractérisée en ce que** le boîtier (26) comporte en-dessous de l'élément de commande (12) un espace d'installation et **en ce que** l'actionneur (32) est agencé pour obtenir un angle aussi faible que possible entre l'axe de mouvement actif (38) de l'élément d'entraînement (34) de l'actionneur (32) et l'axe de mouvement latéral (20) de l'élément de commande (12), aussi près que l'espace d'installation le permet en-dessous de l'élément de commande (12) et/ou aussi éloigné que l'espace d'installation le permet du centre de gravité (40) de l'élément de commande (12).

6. Unité de commande selon l'une des revendications 1 à 5, **caractérisée en ce que** les axes actifs de ressort (42, 42') se trouvent sur l'axe de mouvement latéral (20) ou sur l'axe de mouvement actif (38) de l'élément d'entraînement (34) de l'actionneur (32) ou se trouvent dans un plan (44) essentiellement orthogonal à un plan vertical où se trouvent l'axe de mouvement actif (38) de l'élément d'entraînement (34) de l'actionneur (32) et l'axe de mouvement latéral (20) de l'élément de commande (12) et sont également agencés de manière symétrique par rapport à l'axe de mouvement latéral (20).

7. Unité de commande selon l'une des revendications 1 à 5, **caractérisée en ce que** les couples résultant des ressorts de maintien (22, 24, 24') opérant dans le centre de gravité (40) de l'élément de commande (12) ou du sous-système mobile (41) s'annulent mutuellement, de sorte que l'élément de commande (12), lors de son mouvement de rétroaction le long de l'axe de mouvement actif (38) de l'élément d'entraînement (34) de l'actionneur (32, ne tourne pas en outre ou ne s'incline pas.

**Fig.1**

EP 3 481 662 B1

Messspule

Anker

Luftspaltfeld

Streufeld

Stator

**Fig.2**

Aktorspule

58   60   28

30

52   54

48   56

50

46

**Fig.3**

**Fig.4**

Fig.5

Fig.6

L3=L4

**Fig.7**

L3>L4

**Fig.8**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008035907 A
- DE 102009007243 A
- DE 10043805 A
- JP 2003058321 A
- DE 102012221107 B
- WO 2017129557 A